# EUROPEAN PATENT APPLICATION

(11) **EP 3 534 166 A1**
(43) Date of publication of application: **04.09.2019**
(21) Application number: 17864875.4
(22) Date of filing: 20.10.2017
(51) Int. Cl.: G01R 31/00, H01L 51/50, H05B 33/12

(54) **INSPECTING APPARATUS FOR ORGANIC ELECTRONIC DEVICE, AND METHOD OF INSPECTING ORGANIC ELECTRONIC DEVICE**

(30) Priority: 28.10.2016 JP 2016212068
(71) Applicant: SUMITOMO CHEMICAL COMPANY LIMITED, Chuo-ku Tokyo 104-8260 (JP)
(72) Inventor: AKATSU Mitsutoshi, Niihama-shi Ehime 792-0015 (JP)
(74) Representative: J A Kemp
(86) International application number: PCT/JP2017/038010
(87) International publication number: WO 2018/079435

(57) **Abstract**

An inspecting apparatus according to one embodiment includes: first and second conducting rollers 20A and 20B that are arranged such that roller surfaces 21A and 2IB come into contact with first and second electrode parts 12 and 13 of an organic electronic device 10, and energize the first and second electrode parts; and a data acquisition unit 40 for electrical characteristic inspection of the organic electronic device energized by the first and second conducting rollers. On the roller surface of the first conducting roller, an electrical potential within a contact region in contact with the first electrode part and continuously extending in a circumferential direction is same; and on the roller surface of the second conducting roller, an electrical potential within a contact region in contact with the second electrode part and continuously extending in a circumferential direction is same.

## Description

### Technical Field

The present invention relates to an inspecting apparatus for an organic electronic device and a method of inspecting an organic electronic device.

### Background Art

An organic electronic device is known that has an organic functional layer that exhibits a predetermined function by being supplied power using a first electrode part and a second electrode part. In a process of manufacturing such an organic electronic device, an electrical characteristic of the organic electronic device is inspected. For example, in Patent Literature 1, an inspecting apparatus and an inspecting method using a conducting roller in which pin probes for a first electrode part and a second electrode part are formed on a roller surface are disclosed.

### Citation List

### Patent Literature

Patent Literature 1: WO 2012/172938 A

### Summary of Invention

### Technical Problem

In the technique described in Patent Literature 1, the pin probes are brought into contact with the first electrode part and the second electrode part, by winding an organic electronic device on a conducting roller and bending the organic electronic device, and pressing the organic electronic device against the conducting roller with a press roller.

However, in the technique described in Patent Literature 1, because of using the pin probes and pressing the pin probes against the organic electronic device, there is a possibility that damage such as a hole being made in the organic electronic device occurs in inspection.

Accordingly, an object of the present invention is an object to provide an inspecting apparatus for an organic electronic device and a method of inspecting an organic electronic device capable of performing accurate inspection and preventing damage to an organic electronic device at a time of inspection.

### Solution to Problem

An inspecting apparatus for an organic electronic device according to one aspect of the present invention is an inspecting apparatus for, while continuously conveying an organic electronic device having a first electrode part and a second electrode part, performing electrical characteristic inspection of the organic electronic device. The inspecting apparatus includes: a first conducting roller that is arranged such that a roller surface comes into contact with the first electrode part of the organic electronic device, and energizes the first electrode part; a second conducting roller that is arranged such that a roller surface comes into contact with the second electrode part of the organic electronic device, and energizes the second electrode part; and a data acquisition unit that acquires data for inspection of the organic electronic device energized via the first electrode part and the second electrode part by the first conducting roller and the second conducting roller. On the roller surface of the first conducting roller, an electrical potential within a contact region in contact with the first electrode part and continuously extending in a circumferential direction is same; and on the roller surface of the second conducting roller, an electrical potential within a contact region in contact with the second electrode part and continuously extending in a circumferential direction is same.

In the inspecting apparatus, the contact region of the first electrode part on the roller surface of the first conducting roller is a same electrical potential region in which an electrical potential is same within the contact region, while the contact region of the second electrode part on the roller surface of the second conducting roller is a same electrical potential region in which an electrical potential is same within the contact region. Therefore, the roller surfaces of the first conducting roller and the second conducting roller come into contact with the first electrode part and the second electrode part of the organic electronic device, whereby it is possible to energize the organic electronic device. Since the inspecting apparatus has the data acquisition unit, it is possible to acquire data for electrical characteristic inspection of the energized organic electronic device. Therefore, on the basis of the data that the data acquisition unit has acquired, it is possible to accurately perform electrical characteristic inspection of the organic electronic device. Since the contact region on the roller surface of the first conducting roller is the same electrical potential region and the contact region on the second conducting roller is the same electrical potential region, it is possible to prevent damage to the organic electronic device when energizing the organic electronic device by the first conducting roller and the second conducting roller. Since the inspecting apparatus is capable of, while continuously conveying the organic electronic device having the first electrode part and the second electrode part, performing electrical characteristic inspection of the organic electronic device, it is possible to perform the electrical characteristic inspection while maintaining the productivity.

The inspecting apparatus for the organic electronic device according to an embodiment of the present invention may further include a power supply part that supplies power to the first conducting roller and the second conducting roller, and the power supply part may be electrically connected to a first rotary shaft of the first conducting roller and a second rotary shaft of the second conducting roller, and may supply power to the first conducting roller and the second conducting roller via the first rotary shaft and the second rotary shaft.

In this case, the power supply part may supply power to the first conducting roller and the second conducting roller via a brush, a bearing, or a slipping ring coming into contact with the first rotary shaft and the second rotary shaft. Owing to this, it is possible to supply power to the first conducting roller and the second conducting roller while rotating the first conducting roller and the second conducting roller.

A plurality of sets of the first conducting roller and the second conducting roller may be arranged along a conveying direction of the organic electronic device, and the power supply part may have a switch part that is for turning on/off energization to each of the plurality of sets of the first conducting roller and the second conducting roller, in synchronization with a conveyance speed of the organic electronic device.

In this configuration, it is possible to energize the organic electronic device by each set of the first conducting roller and the second conducting roller, while conveying the organic electronic device. By turning on/off energization to each of the plurality of sets of the first conducting roller and the second conducting roller by the switch part in synchronization with conveyance of the organic electronic device, it is possible to supply predetermined power to the organic electronic device.

The set of the first conducting roller and the second conducting roller may be arranged so as to be able to horizontally support the organic electronic device. Owing to this, it is possible to horizontally convey the organic electronic device, and it is possible to perform electrical characteristic inspection on a horizontal plane of the organic electronic device. Therefore, variations of an inspection result that occur due to the organic electronic device bending are unlikely to occur, so that it is possible to obtain an accurate inspection result.

The data acquisition unit may have a movable part that is for moving in a conveying direction of the organic electronic device, following the organic electronic device being energized by the first conducting roller and the second conducting roller. Owing to this, while energizing the organic electronic device, it is possible to reliably acquire data by the data acquisition unit.

At least one of the first conducting roller or the second conducting roller may have a movable mechanism that is movable in a direction orthogonal to a conveying direction of the organic electronic device. Owing to this, it is possible to inspect organic electronic devices of different sizes with one inspecting apparatus.

The inspecting apparatus for the organic electronic device according to an embodiment of the present invention may include: a first counter roller that is arranged oppositely to the first conducting roller and is for pressing the organic electronic device together with the first conducting roller; and a second counter roller that is arranged oppositely to the second conducting roller and is for pressing the organic electronic device together with the second conducting roller.

In this case, it is possible to press the organic electronic device using the first counter roller and the second counter roller together with the corresponding first conducting roller and second conducting roller. Therefore, the roller surfaces of the first conducting roller and the second conducting roller are likely to come into close contact with the first electrode part and the second electrode part, it is possible to stably energize the organic electronic device via the first conducting roller and the second conducting roller, and it is possible to accurately perform the electrical characteristic inspection.

A plurality of sets of the first conducting roller and the second conducting roller may be arranged in parallel in a direction orthogonal to a conveying direction of the organic electronic device. Owing to this, it is possible to perform inspection of the organic electronic device for each set of the first conducting roller and the second conducting roller arranged in parallel.

A method of inspecting an organic electronic device according to another aspect of the present invention is an inspecting method of, while continuously conveying an organic electronic device having a first electrode part and a second electrode part, performing electrical characteristic inspection of the organic electronic device. The method of inspecting an organic electronic device includes a step of bringing roller surfaces of a first conducting roller and a second conducting roller into respectively contact with the first electrode part and the second electrode part of the organic electronic device being conveyed, energizing the organic electronic device via the roller surfaces of the first conducting roller and the second conducting roller, and inspecting an electrical characteristic of the organic electronic device. On the roller surface of the first conducting roller, an electrical potential within a contact region in contact with the first electrode part and continuously extending in a circumferential direction is same; and on the roller surface of the second conducting roller, an electrical potential within a contact region in contact with the second electrode part and continuously extending in a circumferential direction is same.

In the inspecting method, the contact region of the first electrode part on the roller surface of the first conducting roller is a same electrical potential region in which an electrical potential is same within the contact region, while the contact region of the second electrode part on the roller surface of the second conducting roller is a same electrical potential region in which an electrical potential is same within the contact region. Therefore, the roller surfaces of the first conducting roller and the second conducting roller come into contact with the first electrode part and the second electrode part of the organic electronic device, whereby it is possible to energize the organic electronic device, and accurately perform electrical characteristic inspection. Since the contact region on the roller surface of the first conducting roller is the same electrical potential region and the contact region on the roller surface of the second conducting roller is the same electrical potential region, it is possible to prevent damage to the organic electronic device when energizing the organic electronic device by the first conducting roller and the second conducting roller. Since the inspecting method is capable of, while continuously conveying the organic electronic device having the first electrode part and the second electrode part, performing electrical characteristic inspection of the organic electronic device, it is possible to perform the electrical characteristic inspection while maintaining the productivity.

The present invention also relates to an inspecting apparatus for an organic electronic device, which is an inspecting apparatus for, while continuously conveying an organic electronic device having a first electrode part and a second electrode part, performing electrical characteristic inspection of the organic electronic device. The inspecting apparatus includes: a conducting roller that energizes the first electrode part and the second electrode part of the organic electronic device; and a data acquisition unit that acquires data for inspection of the organic electronic device energized via the first electrode part and the second electrode part by the conducting roller. A roller surface of the conducting roller has a first contact region in contact with the first electrode part and a second contact region in contact with the second electrode part; the first contact region continuously extends in a circumferential direction on the roller surface of the conducting roller, and an electrical potential within the first contact region is same; and the second contact region continuously extends in a circumferential direction on the roller surface of the conducting roller, and an electrical potential within the second contact region is same.

In the inspecting apparatus, the roller surface of the conducting roller has the first contact region in contact with the first electrode part and the second contact region in contact with the second electrode part. The first contact region is a same electrical potential region that extends continuously in a circumferential direction and in which an electrical potential within the first contact region is same, while the second contact region is a same electrical potential region that extends continuously in a circumferential direction and in which an electrical potential within the second contact region is same. Therefore, by bringing the first contact region and the second contact region of the conducting roller into contact with the first electrode part and the second electrode part of the organic electronic device, respectively, it is possible to energize the organic electronic device. Since the inspecting apparatus has the data acquisition unit, it is possible to acquire data for electrical characteristic inspection of the energized organic electronic device. Therefore, on the basis of the data that the data acquisition unit has acquired, it is possible to perform electrical characteristic inspection of the organic electronic device. Since each of the first contact region and second contact region on the roller surface is the same electrical potential region, it is possible to prevent damage to the organic electronic device when energizing the organic electronic device with the conducting roller. Since the inspecting apparatus is capable of, while continuously conveying the organic electronic device having the first electrode part and the second electrode part, performing electrical characteristic inspection of the organic electronic device, it is possible to perform the electrical characteristic inspection while maintaining the productivity.

### Advantageous Effects of Invention

According to the present invention, it is possible to provide an inspecting apparatus for an organic electronic device and a method of inspecting an organic electronic device capable of performing accurate inspection and preventing damage to an organic electronic device at a time of inspection.

### Brief Description of Drawings

FIG. 1 is a schematic view of an inspection target including an organic EL device, which is an example of an organic electronic device.
FIG. 2 is a cross-sectional view taken along line II-II of FIG. 1.
FIG. 3 is a conceptual view of an inspecting apparatus for an organic EL device (organic electronic device).
FIG. 4 is a view for describing the inspecting apparatus including a plurality of sets of a first conducting roller and a second conducting roller.
FIG. 5 is a schematic view showing an example of a specific configuration of the inspecting apparatus for an organic EL device.
FIG. 6 is a schematic view of the inspecting apparatus in viewing from an open arrow direction in FIG. 5.
FIG. 7 is a schematic view of a cross-sectional configuration taken along line VII-VII shown in FIG. 5.
FIG. 8 is a schematic view for describing a modified example of the inspecting apparatus for an organic electronic device.

### Description of Embodiments

Hereinafter, embodiments of the present invention will be described with reference to the drawings. The same elements are denoted by the same reference numerals, and redundant descriptions are omitted. The dimensional ratios of the drawings do not always coincide with those in the description.

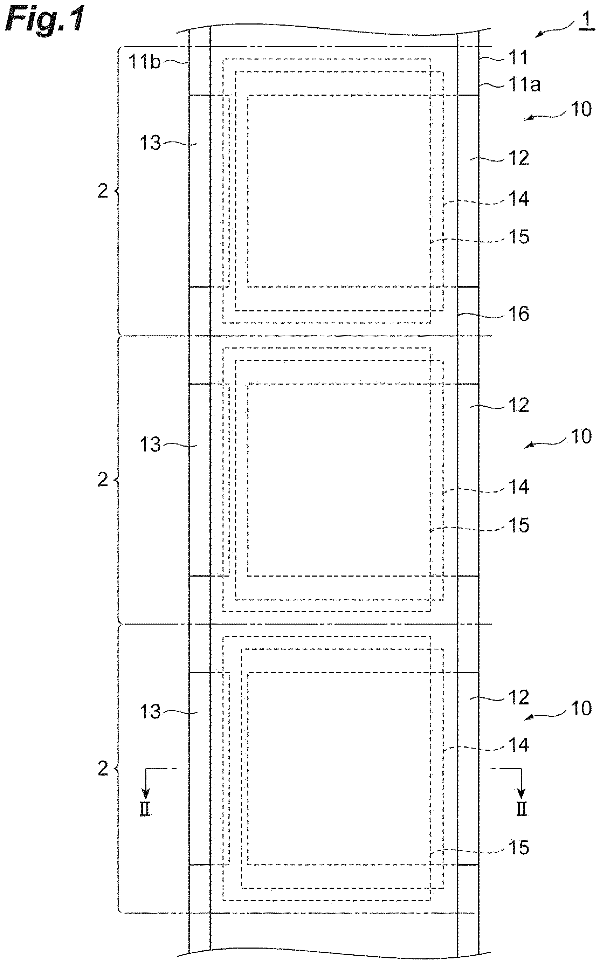

In the present embodiment, as schematically shown in FIG. 1, a mode of, while conveying an inspection target 1, in a longitudinal direction thereof, formed by a plurality of organic electroluminescence devices (organic EL devices) 10 being integrally connected, inspecting an electrical characteristic of each organic EL device (organic electronic device) 10 included in the inspection target 1, will be described. The electrical characteristic inspection of the organic EL device 10 is an inspection to be performed while energizing the organic EL device 10. In the present embodiment, inspection (lighting inspection) based on a light emitting state of the organic EL device 10, which occurs by being energized, will be mainly described.

The inspection target 1 has a long substrate 11. In the inspection target 1, an anode 12, an extraction electrode 13, an organic functional layer 14, and a cathode 15 are provided in each of a plurality of device formation regions 2 that are set in a longitudinal direction of the substrate 11.

By dividing each device formation region 2 from the inspection target 1, a plurality of organic EL devices 10 are obtained. In other words, the inspection target 1 can be an intermediate product at a preceding stage of a step of cutting out the organic EL device 10, in a method of manufacturing the organic EL device 10 with use of the long substrate 11. The inspection target 1 can be manufactured by, for example, a roll-to-roll method.

Typically, in the organic EL device 10, at least the organic functional layer 14 is sealed with a sealing member 16. Therefore, in the present embodiment, as shown in FIG. 1, a mode in which the inspection target 1 has the sealing member 16 will be described.

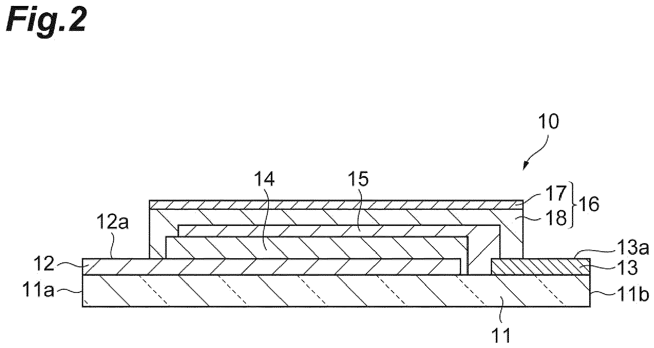

The organic EL device 10 will be described with reference to FIG. 2, which is a cross-sectional view taken along line II-II of FIG. 1. The organic EL device 10 has: the substrate 11; and the anode 12, the extraction electrode 13, the organic functional layer 14, and the cathode 15 that are provided on the substrate 11. The organic EL device 10 described in the present embodiment is a device that emits light from the substrate 11 side (the anode 12 side).

### [Substrate]

For the substrate 11, one that does not chemically change in a step of manufacturing the organic EL device 10 is preferably used. The substrate 11 has translucency for light outputted from the organic EL device 10. The light outputted from the organic EL device 10 may include visible light (light with a wavelength of 400 nm to 800 nm). Examples of the substrate 11 include a glass plate, a polymer film (for example, a plastic film), and the like. It is preferable that substrate 11 is a flexible substrate. A thickness of the substrate 11 is, for example, 30 µm or more and 700 µm or less.

### [Anode]

The anode 12 is provided on the substrate 11 and in the vicinity of a substrate edge portion 11a extending in the longitudinal direction of the substrate 11. For the anode 12, an electrode exhibiting translucency for light that the organic EL device 10 outputs is used. As the electrode exhibiting translucency, a thin film such as of a metal oxide, a metal sulfide, and a metal in which electric conductivity is high can be used, and one in which light transmittance is high is suitably used. Specifically, a thin film made of an indium oxide, a zinc oxide, a tin oxide, an indium tin oxide (ITO), an indium zinc oxide (IZO), gold, platinum, silver, copper, or the like is used, and among these, a thin film made of an ITO, an IZO, or a tin oxide is suitably used. As the anode 12, it is possible to use an organic transparent conductive film such as of polyaniline or a derivative thereof, or polythiophene or a derivative thereof. The anode 12 may have a network structure having a conductor (for example, metal).

A thickness of the anode 12 can be appropriately selected in consideration of light transmission, electrical resistance, and the like, and is, for example, 10 nm to 10 µm, preferably 20 nm to 1 µm, and more preferably 50 nm to 500 nm.

The anode 12 may be formed by a vacuum film forming method, an ion plating method, a plating method, a coating method, or the like. Examples of the coating method include an ink jet printing method, a slit coating method, a micro gravure coating method, a gravure coating method, a bar coating method, a roll coating method, a wire bar coating method, a spray coating method, a screen printing method, a flexographic printing method, an offset printing method, a nozzle printing method, and the like. Among these, the ink jet printing method is preferable.

A part of the anode 12 is exposed to the outside of the sealing member 16. In the anode 12, a portion exposed from the sealing member 16 functions as an external connection region.

### [Extraction Electrode]

The extraction electrode 13 extends in the longitudinal direction of the substrate 11 on the substrate 11, and is provided spaced apart from the anode 12, in the vicinity of a substrate edge portion 11b on a side opposite to the substrate edge portion 11a. A material, a thickness, and the like of the extraction electrode 13 may be similar to those of the anode 12. The extraction electrode 13 is connected to the cathode 15, and the extraction electrode 13 constitutes a second electrode part together with the cathode 15 with respect to the anode 12, which is a first electrode part. A part of the extraction electrode 13 is exposed to the outside of the sealing member 16, and in the extraction electrode 13, a portion exposed from the sealing member 16 functions as an external connection region.

### [Organic Functional Layer]

The organic functional layer 14 is provided between the cathode 15 and the anode 12, and is an organic EL functional unit that contributes to light emission of the organic EL device 10, such as transfer of charges and recombination of charges, in accordance with power (for example, a voltage) applied to the anode 12 and the cathode 15.

The organic functional layer 14 may be provided on the anode 12 so as to cover a portion of the anode 12 other than the external connection region side (the substrate edge portion 11a side), for example. In this case, a part of the organic functional layer 14 is also provided on a surface of the substrate 11.

The organic functional layer 14 includes a light emitting layer. The light emitting layer is a functional layer having a function of emitting light (including visible light). Typically, the organic functional layer 14 is composed mainly of organic matter that emits at least one of fluorescence or phosphorescence, or this organic matter and a dopant that supports this. The dopant is added, for example, for improvement of luminous efficiency or changing an emission wavelength. The organic matter may be a low molecular compound or a high molecular compound. For a material of the light emitting layer, a known light emitting material in a field of the organic EL device 10 is used. The light emitting layer may be formed by, for example, a coating method. An example of the coating method is similar to the example of the coating method described for the anode 12.

The organic functional layer 14 may have a multilayer structure further having a predetermined functional layer as necessary. For example, a hole injection layer, a hole transport layer, or the like may be provided between the anode 12 and the light emitting layer, and an electron transport layer, an electron injection layer, or the like may be provided between the light emitting layer and the cathode 15.

A thickness of the organic functional layer 14 depends on the layer structure thereof, but is, for example, 1 nm to 5 µm, preferably 10 nm to 1 µm, and more preferably 30 nm to 500 nm.

### [Cathode]

The cathode 15 is provided on the organic functional layer 14 so as not to short-circuit to the anode 12. The cathode 15 is connected to the extraction electrode 13. A part of the cathode 15 may be provided on a surface of the substrate 11. A thickness of the cathode 15 is set in consideration of electric conductivity and durability, and an optimum value varies depending on a material to be used. A thickness of the cathode 15 is typically 10 nm to 10 µm, preferably 20 nm to 1 µm, and more preferably 50 nm to 500 nm.

In order to reflect light, with the cathode 15, from the light emitting layer that the organic functional layer 14 has, and to deliver to the anode 12 side, it is preferable that a material of the cathode 15 is a material in which reflectance is high for the light from the light emitting layer. Examples of the material of the cathode 15 include an alkali metal, an alkaline earth metal, a transition metal, and a group 13 metal of the periodic table. As the cathode 15, it is possible to a transparent conductive electrode made of a conductive metal oxide, a conductive organic matter, and the like.

### [Sealing Member]

The sealing member 16 is a member to seal at least the organic functional layer 14. The sealing member 16 is provided on the cathode 15. In the present embodiment, the sealing member 16 is provided so as to cover the organic functional layer 14 and the cathode 15, and to expose a part of the anode 12 and a part of the extraction electrode 13 from the sealing member 16. The sealing member 16 has a sealing base material 17 and an adhesive layer 18.

The sealing base material 17 is positioned on a side opposite to the substrate 11 in the organic EL device 10. The sealing base material 17 is made of: a metal foil; a barrier film in which a barrier functional layer is formed on a front surface, a back surface, or both surfaces of a transparent plastic film; a thin film glass having flexibility; or a film in which a metal having a barrier property is laminated on a plastic film, or the like, and has moisture barrier function. The sealing base material 17 may have a gas barrier function. As the metal foil, a copper foil, an aluminum foil, or a stainless steel foil is preferable from the viewpoint of barrier properties. A thickness of the metal foil is preferably as thick as possible from the viewpoint of pinhole prevention, but 15 µm to 50 µm is preferable also in consideration of the viewpoint flexibility.

The adhesive layer 18 is provided on a surface of the sealing base material 17 on the substrate 11 side, causes the sealing base material 17 to adhere to the substrate 11 on which the anode 12, the organic functional layer 14, and the cathode 15 are formed, and is used for moisture barrier. The adhesive layer 18 may simply have a thickness capable of burying a laminated structure including the anode 12, the organic functional layer 14, and the cathode 15.

In the inspection target 1, a configuration of the organic EL device 10 formed in each device formation region 2 is the same. Therefore, the anodes 12 that the plurality of organic EL devices 10 has are arranged in one line along the longitudinal direction of the substrate 11. Similarly, the extraction electrodes 13 that the plurality of organic EL devices 10 has are arranged in one line along the longitudinal direction of the substrate 11.

Next, an inspecting apparatus 3 and an inspecting method for inspecting an electrical characteristic of the organic EL device 10 while continuously conveying the inspection target 1 including the organic EL device 10 shown in FIG. 1 will be described.

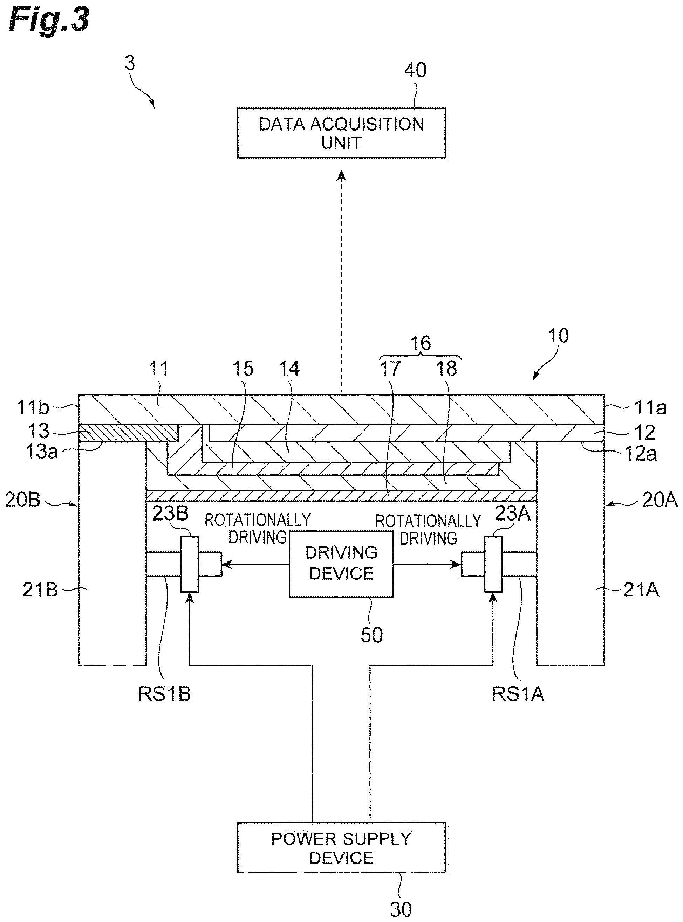

FIG. 3 is a conceptual view of an inspecting apparatus for an organic EL device (organic electronic device). An outline of the inspecting apparatus will be described with reference to FIG. 3. In FIG. 3, a cross-sectional structure of the organic EL device 10 is shown for the purpose of description. From the viewpoint of visibility of the drawing, sizes and the like of constituent elements are emphasized to be illustrated, and are not necessarily coincident with actual dimensions.

The inspecting apparatus 3 includes a first conducting roller 20A, a second conducting roller 20B, and a data acquisition unit 40. FIG. 3 schematically illustrates a power supply device (power supply part) 30 that is for supplying power to the first conducting roller 20A and the second conducting roller 20B, and a driving device 50 that is for driving the first conducting roller 20A and the second conducting roller 20B.

The first conducting roller 20A is a rotary roller to energize the anode 12, which is the first electrode part of the organic EL device 10 that the inspection target 1 has. The first conducting roller 20A is arranged such that a roller surface 21A comes into contact with a surface (surface of the first electrode part) 12a of the anode 12. The roller surface 21A is a smooth curved surface, in other words, configured such that unevenness does not exist substantially. The surface 12a of the anode 12 is a surface of a region (external connection region) exposed from the sealing member 16, of the anode 12. In one embodiment, the roller surface 21A is, for example, in surface contact with the surface 12a of the anode 12.

The first conducting roller 20A has conductivity. In other words, the first conducting roller 20A may be made of a conductive material, for example, such as brass, bronze, white copper, beryllium copper, stainless steel, or aluminum. The first conducting roller 20A may be surface-treated with, for example, gold plating, silver plating, tin plating, nickel plating, or the like, in order to further enhance the conductivity. An electrical potential of the roller surface 21A of the first conducting roller 20A having such a configuration is same in the roller surface 21A. Since the roller surface 21A comes into contact with the surface 12a of the anode 12 while rotating, the roller surface 21A has a contact region continuously extending in the circumferential direction and coming into contact with the surface 12a. Therefore, the contact region on the roller surface 21A is a same electrical potential region in which an electrical potential is same within the contact region.

A rotary shaft (first rotary shaft) RS1A of the first conducting roller 20A is rotationally driven by the driving device 50. Although schematically shown in FIG. 3, as described later, a driving force of the driving device 50 is transmitted to the rotary shaft RS1A by a driving mechanism including a gear mechanism, and the rotary shaft RS1A can be rotationally driven. The rotary shaft RS1A also has conductivity. In other words, the rotary shaft RS1A may be made of a conductive material, for example, such as brass, bronze, white copper, beryllium copper, stainless steel, or aluminum. The rotary shaft RS1A may be surface-treated with, for example, gold plating, silver plating, tin plating, nickel plating, or the like, in order to further enhance the conductivity.

The second conducting roller 20B forms a pair with the first conducting roller 20A, and is a rotary roller to energize the cathode 15 of the organic EL device 10. The second conducting roller 20B is arranged such that a roller surface 21B comes contact with a surface (a surface of the second electrode part) 13a of the extraction electrode 13 constituting the second electrode part together with the cathode 15. The roller surface 21B is a smooth curved surface, in other words, configured such that unevenness does not exist substantially. The surface 13a of the extraction electrode 13 is a surface of a region (external connection region) exposed from the sealing member 16, of the extraction electrode 13. In one embodiment, the roller surface 21B is, for example, in surface contact with the surface 13a of the extraction electrode 13.

Therefore, the second conducting roller 20B is arranged apart from the first conducting roller 20A in a direction orthogonal to a conveying direction of the organic EL device 10. Typically, an interval of the first conducting roller 20A and the second conducting roller 20B is set such that the roller surface 21A and the roller surface 21B come into contact with the surfaces 12a and 13a of the regions exposed from the sealing member 16 in the anode 12 and the extraction electrode 13, and the first conducting roller 20A and the second conducting roller 20B are not positioned on the sealing member 16.

The second conducting roller 20B has conductivity. In other words, the second conducting roller 20B may be made of a conductive material, for example, such as brass, bronze, white copper, beryllium copper, stainless steel, or aluminum. The second conducting roller 20B may be surface-treated with, for example, gold plating, silver plating, tin plating, nickel plating, or the like, in order to further enhance the conductivity. An electrical potential of the roller surface 21B of the second conducting roller 20B having such a configuration is same in the roller surface 21B. Since the roller surface 21B comes into contact with the surface 13a of the extraction electrode 13 while rotating, the roller surface 21B has a contact region continuously extending in the circumferential direction and coming into contact with the surface 13a. Therefore, the contact region on the roller surface 21B is a same electrical potential region in which an electrical potential is same within the connection region.

A rotary shaft (second rotary shaft) RS1B of the second conducting roller 20B is rotationally driven by the driving device 50. Although schematically shown in FIG. 3, similarly to the case of the first conducting roller 20A, a driving force of the driving device 50 is transmitted to the rotary shaft RS1B by the driving mechanism including a gear mechanism, and the rotary shaft RS1B can be rotationally driven. The rotary shaft RS1B also has conductivity. In other words, the rotary shaft RS1B may be made of a conductive material, for example, such as brass, bronze, white copper, beryllium copper, stainless steel, or aluminum. The rotary shaft RS1B may be surface-treated with, for example, gold plating, silver plating, tin plating, nickel plating, or the like, in order to further enhance the conductivity.

A bearing 23A and a bearing 23B having conductivity are attached to the rotary shaft RS1A of the first conducting roller 20A and the rotary shaft RS1B of the second conducting roller 20B, respectively. In order to reduce resistance between the bearings 23A and 23B and the rotary shafts RS1A and RS1B, it is preferable that the bearings 23A and 23B are coated with oil.

The bearing 23A is electrically connected to the power supply device 30, and a positive voltage to be applied to the anode 12 is supplied. As described above, since the first conducting roller 20A and the rotary shaft RS1A also have conductivity, it is possible to apply a positive voltage to the anode 12 via the roller surface 21A, which is the same electrical potential region, by the positive voltage being supplied to the bearing 23A.

Similarly, the bearing 23B is electrically connected to the power supply device 30, and a negative voltage to be applied to the extraction electrode 13 is supplied. Since the second conducting roller 20B and the rotary shaft RS1B also have conductivity, it is possible to apply a negative voltage to the extraction electrode 13 via the roller surface 21B, which is the same electrical potential region, by the negative voltage being supplied to the bearing 23B. Since the extraction electrode 13 is connected to the cathode 15, a negative voltage is applied to the cathode 15 by a negative voltage being applied to the extraction electrode 13.

In this way, upon energizing the organic EL device 10 via the anode 12 and the cathode 15 by the first conducting roller 20A and the second conducting roller 20B, the organic EL device 10 emits light.

The data acquisition unit 40 is provided on a back side of the substrate 11 (a side opposite to the surface in contact with the anode 12), and receives light from the organic EL device 10 that emits light by being energized by the first conducting roller 20A and the second conducting roller 20B via the anode 12 and the cathode 15. Owing to this, data (data for inspection) for electrical characteristic inspection is acquired. Therefore, the data acquisition unit 40 may have, for example, a photodetector. Examples of the photodetector include an image sensor such as a CCD camera, a line sensor, and the like. On the basis of image data (data for inspection) that the data acquisition unit 40 has acquired by receiving the light emission from the organic EL device 10 in this way, for example, electrical characteristic inspection such as light emission unevenness inspection, brightness inspection, or dark spot inspection (including a state of shrinkage) of the organic EL device 10 can be performed.

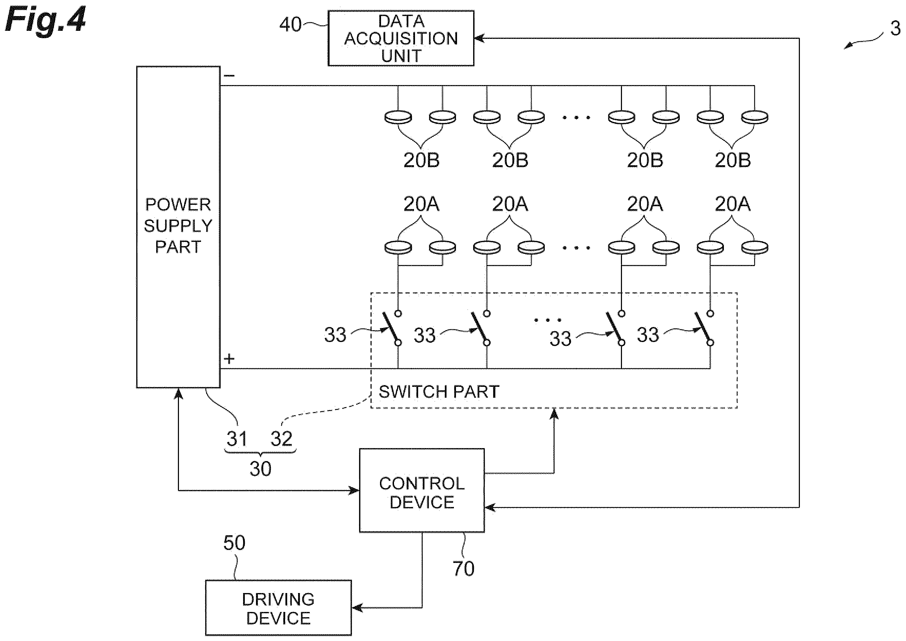

In a case where a combination of one first conducting roller 20A and one second conducting roller 20B shown in FIG. 3 is to be a set of the first conducting roller 20A and the second conducting roller 20B, in the inspecting apparatus 3, a plurality of sets of the first conducting roller 20A and the second conducting roller 20B may be arranged in a conveying direction of the organic EL device 10. This mode will be described with reference to FIG. 4. In the mode shown in FIG. 4, the inspecting apparatus 3 has a control device 70.

FIG. 4 is a conceptual view of the inspecting apparatus 3 focusing on an electrical configuration in the inspecting apparatus 3 in a case where a plurality of sets of the first conducting roller 20A and the second conducting roller 20B are arranged in a conveying direction of the organic EL device 10. In FIG. 4, the first conducting roller 20A and the second conducting roller 20B are schematically shown as a disk-shaped block, and an arrangement direction of the plurality of first conducting rollers 20A (or second conducting rollers 20B) corresponds to a conveying direction of the organic EL device 10 (inspection target 1). As described above, the electrical connection of the power supply device 30 with the first conducting roller 20A and the second conducting roller 20B is performed via the bearings 23A and 23B, but illustration of the bearings 23A and 23B is omitted in FIG. 4.

In the mode in which the inspecting apparatus 3 has the plurality of sets of the first conducting roller 20A and the second conducting roller 20B, the first conducting rollers 20A and the second conducting rollers 20B may be arranged so as to horizontally convey the organic EL device 10. The plurality of first conducting rollers 20A and the plurality of second conducting rollers 20B are configured to synchronously rotate by the driving device 50. This can be realized, as described above, by similarly transmitting a driving force from the driving device 50 to each of the rotary shafts RS1A and the rotary shafts RS1B of the plurality of first conducting rollers 20A and the plurality of second conducting rollers 20B, by the driving mechanism including the gear mechanism.

The plurality of first conducting rollers 20A and the plurality of second conducting rollers 20B that synchronously rotate are arranged so as to come into contact with the surface 12a of the anode 12 and the surface 13a of the extraction electrode 13 of the organic EL device 10. Therefore, the plurality of first conducting rollers 20A and the plurality of second conducting rollers 20B function as a conveyance mechanism of the organic EL device 10 and the inspection target 1 including the organic EL device 10.

In the mode shown in FIG. 4, the power supply device 30 includes a power supply part 31 and a switch part 32.

The power supply part 31 is a power supply source that supplies power to the first conducting roller 20A and the second conducting roller 20B. The power supply part 31 may have a measuring function for a voltage and a current to be supplied to the first conducting roller 20A and the second conducting roller 20B, for electrical characteristic inspection. An example of the power supply part 31 with such a measuring function is a source measure unit (SMU).

A positive electrode terminal of the power supply part 31 is electrically connected to the first conducting roller 20A via the switch part 32, while a negative electrode terminal of the power supply part 31 is electrically connected to the second conducting roller 20B. In a case of having a measuring function for a voltage and a current to be supplied to the first conducting roller 20A and the second conducting roller 20B, the power supply part 31 inputs a measurement result in the power supply part 31 to the control device 70.

The switch part 32 is a circuit to turn on/off energization to each of the plurality of sets of the first conducting roller 20A and the second conducting roller 20B in synchronization with conveyance of the organic EL device 10, and has a plurality of switches 33. The switch part 32 can be realized as, for example, a relay board.

In the mode shown in FIG. 4, as one example, one switch 33 is provided for two adjacent first conducting rollers 20A. One end of the switch 33 is connected to the positive electrode terminal of the power supply part 31, while another end of the switch 33 is electrically connected to the corresponding two first conducting rollers 20A. The switch 33 is on/off controlled in accordance with a control signal from the control device 70.

The control device 70 may be, for example, a computer including a CPU. The control device 70 is electrically connected to the driving device 50, and controls a rotation speed and the like of the first conducting roller 20A and the second conducting roller 20B by the driving device 50.

The control device 70 is electrically connected to the power supply device 30, and controls magnitude of power to be supplied from the power supply part 31 to the first conducting roller 20A and the second conducting roller 20B. The control device 70 may have a function of analyzing an input, if any, of a measurement result of a voltage and a current at the time of energizing the organic EL device 10 from the power supply part 31. In this case, the power supply part 31 and the control device 70 also function as a data acquisition unit.

The control device 70 performs on/off control of each switch 33 in the switch part 32. Specifically, the control device 70 performs relay control on on/off of each switch 33 in synchronization with conveyance of the organic EL device 10 such that predetermined power is supplied to the organic EL device 10 being conveyed, via the first conducting roller 20A and the second conducting roller 20B.

The control device 70 is electrically connected to the data acquisition unit 40 and may have a function of analyzing data that the data acquisition unit 40 has acquired. For example, the control device 70 may have a function of applying image processing for emphasizing unevenness in luminous image in light emission unevenness inspection, or of detecting a defect in defect inspection.

In the mode of the inspecting apparatus 3 having a plurality of sets of the first conducting roller 20A and the second conducting roller 20B in a conveying direction of the organic EL device 10, the data acquisition unit 40 may be configured to be movable following conveyance of the organic EL device 10 being energized. In this case, position control of the data acquisition unit 40 may be performed by the control device 70. Thus, the data acquisition unit 40 moves following conveyance of the organic EL device 10 being energized, whereby it is possible to reliably acquire data necessary for inspection from the organic EL device 10 being energized.

The inspecting apparatus 3 illustrated in FIGS. 3 and 4 may include a movable mechanism that adjusts an interval of the first conducting roller 20A and the second conducting roller 20B. Owing to this, for example, it is possible to inspect organic EL devices 10 of different sizes with one inspecting apparatus 3.

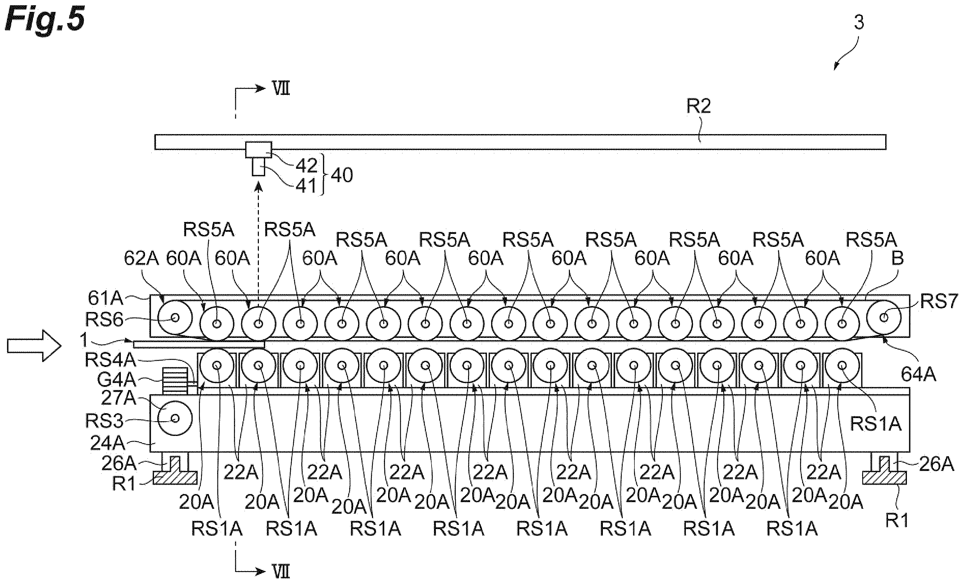

An example of a specific configuration of the inspecting apparatus 3 will be described in detail with reference mainly to FIGS. 5 to 7. As described with reference to FIG. 4, a mode of the inspecting apparatus 3 described with reference to FIGS. 5 to 7 is a mode of having a plurality of sets of the first conducting roller 20A and the second conducting roller 20B in a conveying direction of the organic EL device 10. Hereinafter, unless otherwise noted, the data acquisition unit 40 can move in a conveying direction of the organic EL device 10. Further, unless otherwise noted, the inspecting apparatus 3 is configured such that an interval of the first conducting roller 20A and the second conducting roller 20B is adjustable.

The same reference numerals are given to the elements described with reference to FIGS. 3 and 4, such as the first conducting roller 20A, the second conducting roller 20B, the power supply device 30, and the data acquisition unit 40, and redundant description will be omitted as appropriate.

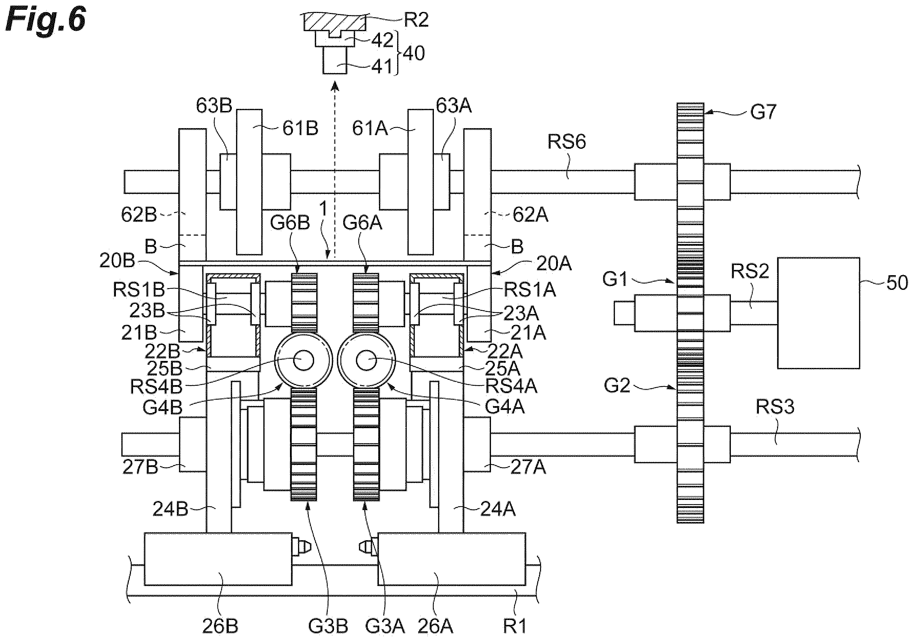

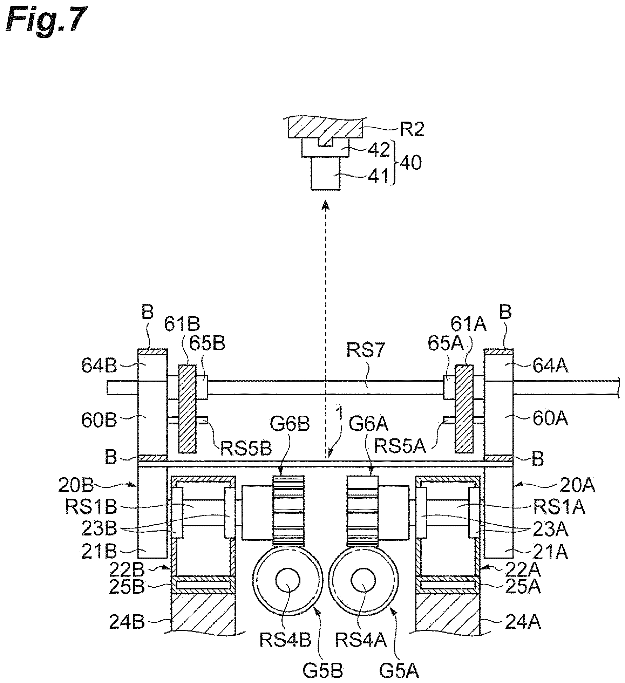

FIG. 5 is a schematic view for describing a configuration of an example of an inspecting apparatus for an organic EL device (organic electronic device). FIG. 6 is a view in viewing from a direction of an open arrow in FIG. 5, while FIG. 7 is a schematic view of a cross-sectional configuration taken along line VII-VII of FIG. 5.

As shown in FIGS. 5 to 7, the inspecting apparatus 3 includes a plurality of first conducting rollers 20A, a plurality of second conducting rollers 20B, the data acquisition unit 40, and the driving device 50. Although illustration is omitted in FIGS. 5 to 7, the inspecting apparatus 3 includes the power supply device (power supply part) 30 and the control device 70, as shown in FIGS. 3 and 4. The inspecting apparatus 3 may include a plurality of first counter rollers 60A and a plurality of second counter rollers 60B. Unless otherwise noted, a mode of having the plurality of first counter rollers 60A and the plurality of second counter rollers 60B will be described. Further, the description overlapping with the contents described with reference to FIGS. 3 and 4 will be appropriately omitted or described in a simplified manner.

First, a configuration located mainly on a lower side from the inspection target 1 in the inspecting apparatus 3 shown in FIGS. 5 to 7 will be described.

In the inspecting apparatus 3 shown in FIGS. 5 to 7, the sets of the first conducting roller 20A and the second conducting roller 20B are arranged apart with respect to a conveying direction of the inspection target 1. Adjacent sets of the first conducting roller 20A and the second conducting roller 20B have an interval, such that the number of sets of the first conducting roller 20A and the second conducting roller 20B, which are in contacted with the anode 12 and the extraction electrode 13 of each organic EL device 10, are the same when the plurality of organic EL devices 10 in the inspection target 1 are conveyed. Owing to this, it is possible to supply the same power to one organic EL device 10 via the set of the first conducting roller 20A and the second conducting roller 20B.

The configurations (shape, size, material, and the like) of the first conducting roller 20A and the second conducting roller 20B are the same, and the plurality of first conducting rollers 20A and the plurality of second conducting rollers 20B are arranged such that axes of a rotary shaft (first rotary shaft) RS1A and a rotary shaft (second rotary shaft) RS1B of these are substantially positioned in a same plane (in a horizontal plane). In this configuration, when the inspection target 1 is conveyed by the inspecting apparatus 3, the inspection target 1 is horizontally conveyed by the first conducting roller 20A and the second conducting roller 20B.

As shown in FIGS. 6 and 7, the rotary shafts RS1A and RS1B of the first conducting roller 20A and the second conducting roller 20B are respectively supported rotatably by the bearings 23A and 23B having conductivity and provided on side walls of support boxes 22A and 22B. In FIGS. 6 and 7, cross-sectional configurations of the support boxes 22A and 22B are illustrated for description.

The support boxes 22A and 22B are fixed via wiring boxes 25A and 25B, on support plates 24A and 24B extending in a conveying direction of the inspection target 1. Therefore, the first conducting roller 20A and the second conducting roller 20B are indirectly supported by the support plates 24A and 24B.

The support plates 24A and 24B each are fixed to base parts 26A and 26B. The base parts 26A and 26B are attached to a rail R1 extending in an axial direction of the rotary shafts RS1A and RS1B, and are configured to be movable along the rail R1. Therefore, the first conducting roller 20A and the second conducting roller 20B supported by the support plates 24A and 24B can independently move in an extending direction of the rail R1. As a result, an interval in the axial direction of the rotary shafts RS1A and RS1B can be adjusted. That is, the rail R1 and the base parts 26A and 26B constitute a movable mechanism that is for enabling the first conducting roller 20A and the second conducting roller 20B to move independently.

The wiring boxes 25A and 25B are boxes to allow wires to pass. Inside the wiring boxes 25A and 25B, a wiring line that electrically connects the bearings 23A and 23B to the power supply device 30 (see FIGS. 3 and 4) is passed through. In FIGS. 5 to 7, illustration of the wiring line is omitted. The wiring relation is as described in FIG. 4.

In the inspecting apparatus 3, the plurality of first conducting rollers 20A and the plurality of second conducting rollers 20B are configured to synchronously rotate by the driving device 50. An example of a driving mechanism to synchronously rotate the first conducting roller 20A and the second conducting roller 20B will be described with reference to FIGS. 6 and 7.

The driving device 50 has a rotary shaft RS2 and rotates the rotary shaft RS2 by, for example, a motor. The rotary shaft RS2 is arranged in parallel with the rotary shafts RS1A and RS1B of the first conducting roller 20A and the second conducting roller 20B.

A gear G1 is attached to the rotary shaft RS2, and the gear G1 is meshed with a gear G2 attached to a rotary shaft RS3 arranged in parallel with the rotary shaft RS2. By a gear mechanism configured by the gear G1 and the gear G2, a rotation of the rotary shaft RS2 is transmitted to the rotary shaft RS3.

The rotary shaft RS3 is passed through shaft supporting bodies 27A and 27B attached near respective end parts of the support plate 24A and the support plate 24B. The shaft supporting bodies 27A and 27B are rotatably attached to the support plates 24A and 24B. The shaft supporting bodies 27A and 27B are configured such that a coupling state with the rotary shaft RS3 is adjustable. For example, in the shaft supporting bodies 27A and 27B, the rotary shaft RS3 and the shaft supporting bodies 27A and 27B are coupled by fastening screws, whereas the shaft supporting bodies 27A and 27B are separated from the rotary shaft RS2 by loosening the screws (in other words, the shaft supporting bodies 27A and 27B are to be in an uncoupled state from the rotary shaft RS3).

In a state where the shaft supporting bodies 27A and 27B are coupled to the rotary shaft RS3, the shaft supporting bodies 27A and 27B rotate in accordance with rotation of the rotary shaft RS3. In a state where the shaft supporting bodies 27A and 27B are uncoupled from the rotary shaft RS3, the shaft supporting bodies 27A and 27B do not rotate in accordance with rotation of the rotary shaft RS3, and the support plates 24A and 24B to which the shaft supporting bodies 27A and 27B are attached are movable in the axial direction of the rotary shaft RS2. Accordingly, the shaft supporting bodies 27A and 27B can also be a part of the movable mechanism that is for moving the first conducting roller 20A and the second conducting roller 20B.

To end parts of the shaft supporting bodies 27A and 27B (end parts on the inner side of a pair of the support plates 24A and 24B), gears G3A and G3B are attached. The gears G3A and G3B each mesh with gears G4A and G4B attached to rotary shafts RS4A and RS4B extending in a direction orthogonal to the rotary shaft RS3 (conveying direction of the inspection target 1). Owing to this, when the shaft supporting bodies 27A and 27B rotate in accordance with rotation of the rotary shaft RS3, a rotational force thereof is transmitted to the rotary shafts RS4A and RS4B.

As shown in FIG. 7, at locations where the first conducting rollers 20A and the second conducting rollers 20B are arranged in an extending direction of the rotary shafts RS4A and RS4B, gears G5A and G5B are attached to the rotary shafts RS4A and RS4B. The gears G5A and G5B mesh with gears G6A and G6B attached to the rotary shafts RS1A and RS1B of each first conducting roller 20A and each second conducting roller 20B.

Therefore, the plurality of first conducting rollers 20A and the plurality of second conducting rollers 20B rotate in synchronization with rotation of the rotary shafts RS4A and RS4B via a gear mechanism configured by the gear G5A and the gear G6A and a gear mechanism configured by the gear G5B and the gear G6B. That is, the plurality of first conducting rollers 20A and second conducting rollers 20B rotate in synchronization with rotation of the rotary shaft RS2 of the driving device 50.

In this way, the first conducting roller 20A and the second conducting roller 20B rotate, whereby the inspection target 1 is conveyed. Therefore, the plurality of first conducting rollers 20A and the plurality of second conducting rollers 20B are also the conveyance mechanism of the inspection target 1.

The data acquisition unit 40 has a photodetector 41 that detects light emission of the organic EL device 10 energized by the first conducting roller 20A and the second conducting roller 20B. Examples of the photodetector 41 are an image sensor (area sensor) such as a CCD camera, a line sensor, and the like as described above.

As shown in FIGS. 5 to 7, the data acquisition unit 40 is attached to a rail R2 extending in a conveying direction of the inspection target 1, via a movable device (movable part) 42. The movable device 42 is a device that is electrically connected to the control device 70 (see FIG. 4) and moves on the rail R2 in accordance with an instruction from the control device 70.

Next, a configuration located mainly on an upper side from the inspection target 1 in the inspecting apparatus 3 shown in FIGS. 5 to 7 will be described. In the inspecting apparatus 3, as shown in FIGS. 5 and 7, the plurality of first counter rollers 60A and the plurality of second counter rollers 60B are arranged on the upper side from the inspection target 1.

The number of the plurality of first counter rollers 60A is the same as the number of the plurality of first conducting rollers 20A, and the first counter roller 60A is arranged oppositely to the corresponding first conducting roller 20A. Similarly, the number of the plurality of second counter rollers 60B is the same as the number of the plurality of second conducting rollers 20B, and the second counter roller 60B is arranged oppositely to the corresponding second conducting roller 20B. The first counter roller 60A and the second counter roller 60B are arranged oppositely so as to sandwich the inspection target 1 together with the corresponding first conducting roller 20A and second conducting roller 20B in a thickness direction of the substrate 11.

Rotary shafts RS5A and RS5B of the plurality of first counter rollers 60A and the plurality of second counter rollers 60B are rotatably attached respectively to support plates 61A and 61B extending in an extending direction of the inspection target 1.

As shown in FIGS. 5 and 6, at one end of the support plates 61A and 61B, a rotary shaft RS6 of drive rollers (drive pulleys) 62A and 62B is passed through shaft supporting bodies 63A and 63B attached to the support plates 61A and 61B. The shaft supporting bodies 63A and 63B are rotatably attached to the support plates 61A and 61B. As shown in FIGS. 5 and 7, at another end of the support plates 61A and 61B, a rotary shaft RS7 of tail rollers (tail pulleys) 64A and 64B is passed through shaft supporting bodies 65A and 65B rotatably attached to the support plates 61A and 61B.

Similarly to the case of the shaft supporting bodies 27A and 27B, the shaft supporting bodies 63A and 63B and the shaft supporting bodies 65A and 65B are configured such that coupling states with the rotary shafts RS6 and RS7 are adjustable. That is, a state where the shaft supporting bodies 63A and 63B and the shaft supporting bodies 65A and 65B are coupled with the corresponding rotary shafts RS6 and RS7 and an uncoupled state (separated state) from the rotary shafts RS6 and RS7 are switched.

In a case of a state where the shaft supporting bodies 63A and 63B and the shaft supporting bodies 65A and 65B are coupled with the corresponding rotary shafts RS6 and RS7, the shaft supporting bodies 63A and 63B and the shaft supporting bodies 65A and 65B rotate with the rotation of the rotary shafts RS6 and RS7. In a case where the shaft supporting bodies 63A and 63B and the shaft supporting bodies 65A and 65B are separated from the corresponding rotary shafts RS6 and RS7, it is possible to move the support plates 61A and 61B to which the shaft supporting bodies 63A and 63B are attached, in the axial direction of the rotary shafts RS6 and RS7. Therefore, in a case of adjusting an interval of the first conducting roller 20A and the second conducting roller 20B, it is possible to move the support plates 61A and 61B as well in accordance with movement of the support plates 24A and 24B.

An endless annular belt B is wound on the drive roller 62A, the first counter roller 60A, and the tail roller 64A, and on the drive roller 62B, the second counter roller 60B, and the tail roller 64B. As the belts B rotate with the rotation of the drive rollers 62A and 62B, the first counter roller 60A and the second counter roller 60B also rotate. Therefore, the plurality of first counter rollers 60A and the plurality of second counter rollers 60B rotate synchronously.

The first counter roller 60A and the second counter roller 60B are arranged with gaps between the corresponding first conducting roller 20A and second conducting roller 20B, so as to sandwich the inspection target 1 together with the corresponding first conducting roller 20A and second conducting roller 20B via the belts B.

As shown in FIG. 6, to the rotary shaft RS6 of the drive rollers 62A and 62B, a gear G7 is attached. The gear G7 meshes with the gear G1 of the rotary shaft RS2 extending from the driving device 50. Owing to this, the drive rollers 62A and 62B rotate with the rotation of the rotary shaft RS2 of the driving device 50. Therefore, the first counter roller 60A and the second counter roller 60B rotate in synchronization with rotation of the first conducting roller 20A and the second conducting roller 20B.

As shown in FIG. 4, the control device 70 is electrically connected to the power supply device 30, the data acquisition unit 40, and the driving device 50. The control on the power supply device 30, the data acquisition unit 40, and the driving device 50 by the control device 70 is similar to that in the case described with reference to FIG. 4, so that the description will be omitted.

In the mode in which the data acquisition unit 40 has the movable device 42, the control device 70 controls the movable device 42 in accordance with a conveyance state of the organic EL device 10 such that the data acquisition unit 40 can acquire light that the organic EL device 10 as the inspection target has emitted. For example, the control device 70 moves the movable device 42 in accordance with movement of the organic EL device 10 to which power is being supplied.

Next, an inspecting method for the organic EL device 10 using the inspecting apparatus 3 shown in FIGS. 5 to 7 will be described. In the inspecting apparatus 3, as the driving device 50 rotationally drives the rotary shaft RS2, the first conducting roller 20A and the second conducting roller 20B of each set rotate in synchronization with rotation of the rotary shaft RS2, the belts B rotate, and the plurality of first counter rollers 60A and the plurality of second counter rollers 60B rotate in synchronization with rotation of the rotary shaft RS2.

In this way, in a state where the first conducting roller 20A, the second conducting roller 20B, the first counter roller 60A, and the second counter roller 60B are made to rotate, the inspection target 1 is carried between the belts B and the first conducting roller 20A and the second conducting roller 20B. At this time, the inspection target 1 is carried into the inspecting apparatus 3 such that the surface 12a of the anode 12 and the surface 13a of the extraction electrode 13 are positioned on a side where the first conducting roller 20A and the second conducting roller 20B are arranged.

The inspection target 1 carried between the belts B and the first conducting roller 20A and the second conducting roller 20B is horizontally conveyed while being in contact with the roller surfaces 21A and 21B, with the rotation of the first conducting roller 20A and the second conducting roller 20B. In the mode illustrated in FIG. 5, the inspection target 1 is horizontally conveyed from the left side to the right side.

While conveying the inspection target 1 in this way, the inspecting apparatus 3 supplies power to the first conducting roller 20A and the second conducting roller 20B of each set by the power supply device 30, and energizes the organic EL device 10 that the inspection target 1 has. The photodetector 41 of the data acquisition unit 40 receives the light emitted from the organic EL device 10 through this energization, whereby the data acquisition unit 40 acquires data for inspection of the organic EL device 10 and performs electrical characteristic inspection (inspecting step).

By the data acquisition unit 40 acquiring data for inspection (for example, luminous image data) in this way, it is possible to perform electrical characteristic inspection such as, for example, emission unevenness inspection, luminance inspection, and dark spot inspection (including a state of shrinkage). It is also possible to perform image-analysis on image data that the data acquisition unit 40 has acquired, by the control device 70.

In supplying power with the power supply device 30 to the first conducting roller 20A and the second conducting roller 20B of each set, the control device 70 controls the switch part 32 that the power supply device 30 has. Specifically, during a time required for inspection of the predetermined organic EL device 10 among the plurality of organic EL devices 10 that the inspection target 1 has, the control device 70 sequentially switches the switch 33 of the switch part 32 such that it is possible to supply predetermined power via the first conducting roller 20A and the second conducting roller 20B.

At the same time, the control device 70 controls the movable device 42 to move the data acquisition unit 40 in a conveying direction of the inspection target 1 such that the photodetector 41 of the data acquisition unit 40 follows the predetermined organic EL device 10 being energized. Owing to this, it is possible for the photodetector 41 to reliably receive the light from the energized organic EL device 10 for the time required for the inspection.

Operational effects of the inspecting apparatus 3 and the inspecting method using the inspecting apparatus 3 will be described.

The roller surfaces 21A and 21B of the first conducting roller 20A and the second conducting roller 20B are surface-shaped same electrical potential regions continuously extending in the circumferential direction, and form a smooth curved surface. Then, the first conducting roller 20A and the second conducting roller 20B are arranged such that the roller surfaces 21A and 21B, which are the same electrical potential region, come into contact with the surfaces 12a and 13a of the anode 12 and the extraction electrode 13 of the organic EL device 10. Therefore, it is possible to easily energize the organic EL device 10 by supplying power to the first conducting roller 20A and the second conducting roller 20B via the rotary shafts RS1A and RS1B of the first conducting roller 20A and the second conducting roller 20B when the organic EL device 10 passes over the first conducting roller 20A and the second conducting roller 20B.

The first conducting roller 20A and the second conducting roller 20B, in which the roller surfaces 21A and 21B are the surface-shaped same electrical potential regions continuously extending in the circumferential direction, are easy to manufacture because of a simple configuration. For example, by using a conductive material, the first conducting roller 20A and the second conducting roller 20B can be easily manufactured. As a result, it is possible to achieve reduction of the manufacturing cost of the inspecting apparatus 3.

Since the roller surfaces 21A and 21B, which are the same electrical potential regions, come into contact with the corresponding anode 12 and extraction electrode 13 with a surface, damage such as a hole being made in the organic EL device 10 is unlikely to occur even in energizing the organic EL device 10 via the roller surfaces 21A and 21B. As a result, it is possible to achieve improvement of the manufacturing yield of the organic EL device 10.

Since the roller surfaces 21A and 21B of the first conducting roller 20A and the second conducting roller 20B are surface-shaped same electrical potential regions continuously extending in the circumferential direction, it is possible to stably supply constant power to the anode 12 and the extraction electrode 13 while the organic EL device 10 passes over the first conducting roller 20A and the second conducting roller 20B. As a result, even in inspecting while conveying the organic EL device 10, an inspection error due to fluctuation of power to be supplied to the organic EL device 10 is not to occur, so that it is possible to accurately perform the inspection.

The power supply device 30 supplies power to the first conducting roller 20A and the second conducting roller 20B via the bearings 23A and 23B attached to the rotary shafts RS1A and RS1B. Therefore, even when the first conducting roller 20A and the second conducting roller 20B are rotating, it is possible to stably and easily supply power to the first conducting roller 20A and the second conducting roller 20B.

In the mode of supplying power to the first conducting roller 20A and the second conducting roller 20B via the rotary shafts RS1A and RS1B, the roller surfaces 21A and 21B of the first conducting roller 20A and the second conducting roller 20B do not suffer damage due to power supply, and unnecessary force does not act on side surfaces of the first conducting roller 20A and the second conducting roller 20B. As a result, even when the roller surfaces 21A and 21B are brought into contact with the organic EL device 10 for power supply to the organic EL device 10, the organic EL device 10 does not suffer damage, and it is possible to more accurately bring the roller surfaces 21A and 21B into contact with the anode 12 and the extraction electrode 13.

The inspecting apparatus 3 has the first conducting roller 20A and the second conducting roller 20B for energization to the anode 12 and the extraction electrode 13, respectively. The first conducting roller 20A and the second conducting roller 20B are supported by the support plates 24A and 24B, and the support plates 24A and 24B are attached to the rail R1 via the base parts 26A and 26B. Further, the shaft supporting bodies 27A and 27B attached to the support plates 24A and 24B are movable with respect to the rotary shaft RS3. Therefore, in the inspecting apparatus 3, a distance between the first conducting roller 20A and the second conducting roller 20B is variable. That is, the inspecting apparatus 3 has the movable mechanism that is for adjusting a distance between the first conducting roller 20A and the second conducting roller 20B.

Therefore, for example, with the use of one inspecting apparatus 3, it is possible to inspect the inspection target 1 including the organic EL device 10 having a first size, together with the inspection target 1 including the organic EL device 10 having a second size different from the first size. In other words, the inspecting apparatus 3 has versatility. As a result, the cost required for the inspection of the organic EL device 10 decreases. Furthermore, since replacement of the first conducting roller 20A and the second conducting roller 20B is unnecessary for inspection of the organic EL devices 10 of different sizes, it is also possible to achieve improvement of the productivity of the organic EL device 10.

Since replacement of the first conducting roller 20A and the second conducting roller 20B is unnecessary, in manufacturing of the organic EL device 10, it is not necessary to set an inspecting step of the organic EL device 10 as a single inspection line separated from other steps. As a result, it is easy to combine with other steps in manufacturing of the organic EL device 10, and it is easy to feed back an inspection result to a step upstream from the inspecting step in a case where an abnormality is found in the organic EL device 10 as a result of the inspection.

In a mode of including the first counter roller 60A and the second counter roller 60B, it is possible to press the organic EL device 10 by the first counter roller 60A and the second counter roller 60B, together with the first conducting roller 20A and the second conducting roller 20B. Therefore, since it is possible to more reliably bring the roller surfaces 21A and 21B into contact with the surfaces 12a and 13a of the anode 12 and the extraction electrode 13, it is possible to stably energize the organic EL device 10.

In the inspecting apparatus 3, electrical characteristic inspection of the organic EL device 10 is possible while horizontally conveying the inspection target 1. Therefore, as compared with a case of bending and inspecting the inspection target 1, for example, as in Patent Literature 1, it is not necessary to give a tension to the organic EL device 10 more than necessary for the inspection. As a result, it is possible to prevent damage due to a tension applied to the organic EL device 10 for inspection, so that productivity improves.

In the inspecting apparatus 3, since inspection is possible while horizontally conveying the organic EL device 10, it is possible to use an area sensor such as a CCD camera as the photodetector 41. Since the inspection is performed while conveying the organic EL device 10, it is necessary to adjust a conveyance speed in order to ensure signal strength to the degree enabling inspection by the photodetector 41. In an area sensor, a condition of a conveyance speed for increasing the signal strength is relaxed as compared with a line sensor. As a result, it is possible to inspect the organic EL device 10 more efficiently.

In the mode in which the data acquisition unit 40 has the movable device 42, even when the organic EL device 10 is being conveyed, it is possible to move the photodetector 41 of the data acquisition unit 40 following the organic EL device 10 being energized by the first conducting roller 20A and the second conducting roller 20B, in a conveying direction of the organic EL device 10. In this case, while further reducing the influence of a conveyance speed, it is possible to reliably obtain a signal strength required by the data acquisition unit 40 for the inspection. In other words, the data acquisition unit 40 can reliably acquire data for electrical characteristic inspection. Therefore, it is possible to inspect the organic EL device 10 more efficiently.

Since the inspecting apparatus 3 is capable of inspecting while horizontally conveying the organic EL device 10, it is possible to inspect emission unevenness and the like in the planar-shaped organic EL device 10, for example, when performing lighting inspection as exemplified as the electrical characteristic inspection. Therefore, it is possible to inspect the organic EL device 10 in a state closer to a use state.

Various embodiments and examples of the present invention have been described above. However, the present invention is not limited to the various embodiments and examples described above, and various modifications are possible without departing from the spirit of the present invention.

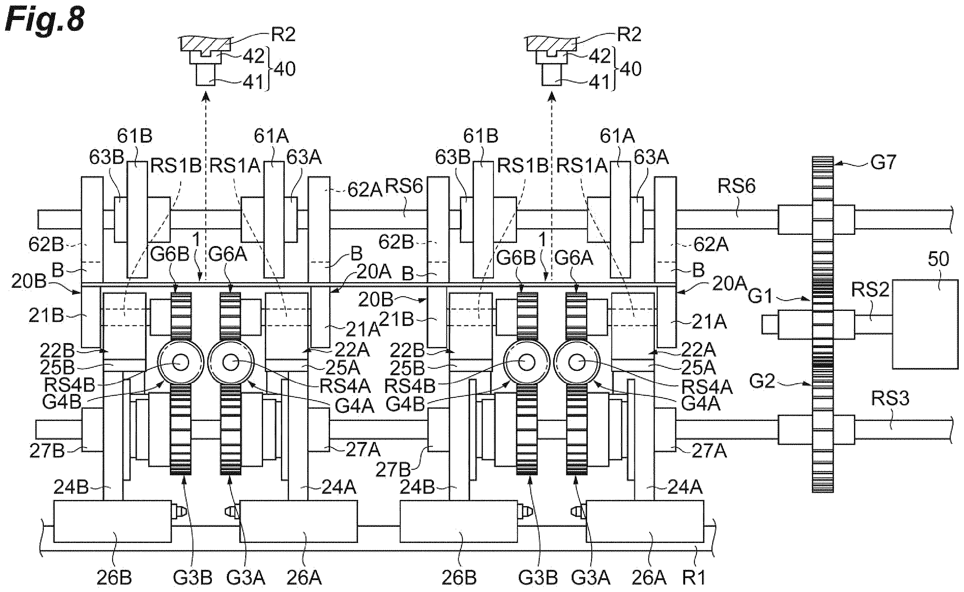

FIG. 1 has illustrated the inspection target 1 having only one row of the plurality of organic EL devices 10. However, for example, the present invention is applicable to an inspection target 1 in which two or more rows of the plurality of organic EL devices 10 are arranged in parallel. In this case, as shown in FIG. 8, it is sufficient to arrange a set of the first conducting roller 20A and the second conducting roller 20B in parallel in a direction orthogonal to a conveying direction of the inspection target 1, in accordance with the number of rows of the plurality of organic EL devices 10. FIG. 7 has illustrated the case where the inspection target 1 has two rows of the plurality of organic EL devices 10.

A distance between the first conducting roller and the second conducting roller may be fixed. In this case, the inspecting apparatus does not have a mechanism that makes the distance variable between the first conducting roller and the second conducting roller. In other words, the inspecting apparatus does not have the movable mechanism for moving the first conducting roller and the second conducting roller in a direction orthogonal to a conveying direction of the organic EL device. For example, in the mode shown in FIGS. 5 to 7, for example, the rail R1 and the base parts 26A and 26B are unnecessary, and furthermore, the shaft supporting bodies 27A and 27B may be fixed to the rotary shaft RS3, and the shaft supporting bodies 63A and 63B and the shaft supporting bodies 65A and 65B may also be fixed to the rotary shafts RS6 and RS7.

The movable mechanism of the inspecting apparatus may be configured to move both the first conducting roller and the second conducting roller, or may be configured to move either the first conducting roller or the second conducting roller.

The inspecting apparatus does not necessarily include the first counter roller and the second counter roller. Further, the data acquisition unit may be fixed at a predetermined position without having the movable device. Further, the inspecting apparatus may simply have at least one set of the first conducting roller and the second conducting roller.

For example, it is also possible to inspect an organic EL device of a sheet shape with the inspecting apparatus. Also in this case, the roller surfaces of the first conducting roller and the second conducting roller are surface-shaped same electrical potential regions continuously extending in the circumferential direction, and the first conducting roller and the second conducting roller are provided such that the roller surfaces come into contact with the surfaces of the anode and the extraction electrode of the organic EL device. Therefore, the organic EL device is unlikely to suffer damage in energizing the organic EL device through the first conducting roller and the second conducting roller.

The entire roller surfaces of the first conducting roller and the second conducting roller need not be the same electrical potential regions. It suffices that, on the roller surfaces of the first conducting roller and the second conducting roller, a region, which continuously extends in the circumferential direction and comes into contact with the surface of the anode (the first electrode part) and the surface of the extraction electrode (the second electrode part) with the rotation of the first conducting roller and the second conducting roller, is the same electrical potential region. Therefore, the same electrical potential region may be a region continuously extending in the circumferential direction and being in a linear or a surface shape narrower than a width direction of the roller surface.

The data acquisition unit may have a luminance meter instead of the photodetector such as a CCD camera. The electrical characteristic inspection is not limited to the inspection of a light emitting state from the organic EL device, and an inspection performed by energizing the organic EL device, for example, such as current-voltage characteristics or leakage inspection in energizing the organic EL device, is sufficient. For example, in a case of inspection of current-voltage characteristics, it is possible to perform by adopting the SCU as power supply as described above, and in this case, the power supply also has a function of the data acquisition unit.

A member to supply power to the rotary shafts of the first conducting roller and the second conducting roller is not limited to bearings. For example, it is possible to supply power to the rotary shaft via a conductive brush or a slipping ring coming into contact with the rotary shafts of the first conducting roller and the second conducting roller. Also in this case, it is possible to supply power to the first conducting roller and the second conducting roller while rotating the first conducting roller and the second conducting roller. The inspecting apparatus need not include the member, as long as the first rotary shaft of the first conducting roller and the second rotary shaft of the second conducting roller are electrically connected to the power supply device and it is possible to supply power to the first conducting roller and the second conducting roller via the first rotary shaft and the second rotary shaft.

The mode of including the first conducting roller coming into contact with the first electrode part and the second conducting roller coming into contact with the second electrode part for the organic EL device has been described. However, the inspecting apparatus may include one conducting roller for the first electrode part and the second electrode part. In this case, for example, the conducting roller may be configured such that, on the roller surface of the conducting roller, the first contact region extending continuously in the circumferential direction and coming into contact with the first electrode part and the second contact region coming into contact with the second electrode part become individually independent same electrical potential regions. For example, the first contact region and the second contact region are formed as protrusions having conductivity and protruding outward in a radial direction from the roller surface. Then, a distal end surfaces of the protrusions (a surface in contact with the first electrode part and the second electrode part) may be made smooth, and the protrusion as the first contact region and the protrusion as the second contact region may simply be insulated from each other. In this case, by supplying a predetermined voltage to each of the protrusion as the first contact region and the protrusion as the second contact region, it is possible to energize the organic EL device. Then, since the distal end surface of the protrusion is a smooth surface, it is possible to prevent damage to the organic EL device at the time of inspection.

The present invention is not limited to a mode of emitting light from the anode side, and is applicable to an organic EL device that generates light from the cathode side. The present invention is also applicable to organic electronic devices other than organic EL devices, for example, such as organic solar cells, organic photodetectors, and organic transistors.

### Reference Signs List

- 3: inspecting apparatus
- 10: organic EL device
- 12: anode (first electrode part)
- 12a: surface (surface of first electrode part)
- 13: extraction electrode (second electrode part)
- 13a: surface (surface of second electrode part)
- 15: cathode (second electrode part)
- 20A: first conducting roller
- 20B: second conducting roller
- 21A, 21B: roller surface (same electrical potential region)
- 23A, 23B: bearing
- 26A, 26B: base part (movable mechanism)
- 27A, 27B: shaft supporting body (movable mechanism)
- 30: power supply device (power supply part)
- 32: switch part
- 40: data acquisition unit
- 42: movable device (movable part)
- 60A: first counter roller
- 60B: second counter roller
- R1: rail (movable mechanism)
- RS1A: rotary shaft (first rotary shaft)
- RS1B: rotary shaft (second rotary shaft)

## Claims

1. An inspecting apparatus for an organic electronic device,
the inspecting apparatus being for, while continuously conveying an organic electronic device having a first electrode part and a second electrode part, performing electrical characteristic inspection of the organic electronic device, the inspecting apparatus comprising:
a first conducting roller arranged such that a roller surface comes into contact with the first electrode part of the organic electronic device, and configured to energize the first electrode part;
a second conducting roller arranged such that a roller surface comes into contact with the second electrode part of the organic electronic device, and configured to energize the second electrode part; and
a data acquisition unit configured to acquire data for inspection of the organic electronic device energized via the first electrode part and the second electrode part by the first conducting roller and the second conducting roller, wherein
on a roller surface of the first conducting roller, an electrical potential within a contact region in contact with the first electrode part, the contact region continuously extending in a circumferential direction, is same, and
on a roller surface of the second conducting roller, an electrical potential within a contact region in contact with the second electrode part, the contact region continuously extending in a circumferential direction, is same.

2. The inspecting apparatus for an organic electronic device according to claim 1, further comprising:
a power supply part configured to supply power to the first conducting roller and the second conducting roller, wherein
the power supply part is electrically connected to a first rotary shaft of the first conducting roller and a second rotary shaft of the second conducting roller, and supplies power via the first rotary shaft and the second rotary shaft to the first conducting roller and the second conducting roller.

3. The inspecting apparatus for an organic electronic device according to claim 2, wherein
the power supply part supplies power to the first conducting roller and the second conducting roller via a brush, a bearing, or a slipping ring coming contact with the first rotary shaft and the second rotary shaft.

4. The inspecting apparatus for an organic electronic device according to claim 2 or 3, wherein
a plurality of sets of the first conducting roller and the second conducting roller is arranged along a conveying direction of the organic electronic device, and
the power supply part has a switch part configured to turn on/off energization to each of a plurality of sets of the first conducting roller and the second conducting roller, in synchronization with a conveyance speed of the organic electronic device.

5. The inspecting apparatus for an organic electronic device according to claim 4, wherein
a plurality of sets of the first conducting roller and the second conducting roller are arranged to be able to horizontally support the organic electronic device.

6. The inspecting apparatus for an organic electronic device according to claim 4 or 5, wherein
the data acquisition unit has a movable part configured to move in a conveying direction of the organic electronic device, following the organic electronic device being energized by the first conducting roller and the second conducting roller.

7. The inspecting apparatus for an organic electronic device according to any one of claims 1 to 5, wherein at least one of the first conducting roller or the second conducting roller has a movable mechanism being movable in a direction orthogonal to a conveying direction of the organic electronic device.

8. The inspecting apparatus for an organic electronic device according to any one of claims 1 to 6, further comprising:
a first counter roller arranged oppositely to the first conducting roller and configured to press the organic electronic device together with the first conducting roller; and
a second counter roller arranged oppositely to the second conducting roller and configured to press the organic electronic device together with the second conducting roller.

9. The inspecting apparatus for an organic electronic device according to any one of claims 1 to 7, wherein
a plurality of sets of the first conducting roller and the second conducting roller are arranged in parallel in a direction orthogonal to a conveying direction of the organic electronic device.

10. A method of inspecting an organic electronic device,
the method being an inspecting method of, while continuously conveying an organic electronic device having a first electrode part and a second electrode part, performing electrical characteristic inspection of the organic electronic device, the method comprising:
a step of bringing roller surfaces of a first conducting roller and a second conducting roller into respectively contact with the first electrode part and the second electrode part of the organic electronic device being conveyed, energizing the organic electronic device via roller surfaces of the first conducting roller and the second conducting roller, acquiring data for inspection of the organic electronic device, and inspecting an electrical characteristic, wherein
on a roller surface of the first conducting roller, an electrical potential within a contact region in contact with the first electrode part, the contact region continuously extending in a circumferential direction, is same, and
on a roller surface of the second conducting roller, an electrical potential within a contact region in contact with the second electrode part, the contact region continuously extending in a circumferential direction, is same.

11. An inspecting apparatus for an organic electronic device,
the inspecting apparatus being for, while continuously conveying an organic electronic device having a first electrode part and a second electrode part, performing electrical characteristic inspection of the organic electronic device, the inspecting apparatus comprising:
a conducting roller configured to energize the first electrode part and the second electrode part of the organic electronic device; and
a data acquisition unit configured to acquire data for inspection of the organic electronic device energized via the first electrode part and the second electrode part by the conducting roller, wherein
a roller surface of the conducting roller has a first contact region in contact with the first electrode part and a second contact region in contact with the second electrode part,
the first contact region continuously extends in a circumferential direction on a roller surface of the conducting roller, and an electrical potential within the first contact region is same, and
the second contact region continuously extends in a circumferential direction on a roller surface of the conducting roller, and an electrical potential within the second contact region is same.
